# EUROPÄISCHE PATENTANMELDUNG

(11) **EP 1 672 714 A2**
(43) Veröffentlichungstag der Anmeldung: **21.06.2006**
(21) Anmeldenummer: 06007372.3
(22) Anmeldetag: 03.03.2005
(51) Int. Cl.: H01L 51/30

(54) **Dotand und Verfahren zu seiner Herstellung**

(30) Priorität: 03.03.2004 DE 102004010954
(62) Teilanmeldung aus: 05729708.7
(71) Anmelder: Novaled GmbH, 01307 Dresden (DE)
(72) Erfinder: Werner, Ansgar, 01277 Dresden (DE); Kühl, Olaf, 04416 Markkleeberg (DE); Gessler, Simon, 69117 Heidelberg (DE); Harada, Kentaro, 01307 Dresden (DE); Hartmann, Horst, 01326 Dresden (DE); Grüssing, André, 01307 Dresden (DE); Limmert, Michael, 01277 Dresden (DE); Lux, Andrea, 01309 Dresden (DE)
(74) Vertreter: Bittner, Thomas L.

(57) **Zusammenfassung**

Die Erfindung betrifft neue n-Dotanden und Verfahren zu ihrer Herstellung.

## Beschreibung

Die Erfindung betrifft n-Dotanden und Verfahren zu ihrer Herstellung.

Es ist bekannt, organische Halbleiter durch Dotierung hinsichtlich ihrer elektrischen Eigenschaften, insbesondere ihrer elektrischen Leitfähigkeit, zu verändern, wie dies auch bei anorganischen Halbleitern wie Siliciumhalbleitern der Fall ist. Hierbei wird durch Erzeugung von Ladungsträgern im Matrixmaterial eine Erhöhung der zunächst recht niedrigen Leitfähigkeit sowie je nach Art des verwendeten Dotanden eine Veränderung im Fermi-Niveau des Halbleiters erreicht. Eine Dotierung führt hierbei zu einer Erhöhung der Leitfähigkeit von Ladungstransportschichten, wodurch ohmsche Verluste verringert werden, und zu einem verbesserten Übergang der Ladungsträger zwischen Kontakten und organischer Schicht. Anorganische Dotanden sind bei organischen Matrixmaterialien aufgrund ihrer hohen Diffusionskoeffizienten meist nachteilig, da sie die Funktion und Stabilität der elektronischen Bauelemente beeinträchtigen. Ferner ist es bekannt, Dotanden über chemische Reaktionen in dem halbleitenden Matrixmaterial freizusetzen, um Dotanden bereitzustellen. Das Oxidationspotential der derart freigesetzten Dotanden ist jedoch für verschiedene Anwendungsfälle wie insbesondere für organische Leuchtdioden (OLED) oftmals nicht ausreichend. Ferner werden bei Freisetzung der Dotanden auch weitere Verbindungen und/oder Atome, beispielsweise atomarer Wasserstoff, erzeugt, wodurch die Eigenschaften der dotierten Schicht bzw. des korrespondierenden elektronischen Bauelementes beeinträchtigt werden.

Ferner haben als Dotanden verwendete organische Verbindungen oftmals ein nicht ausreichend niedriges Oxidationspotential für den jeweiligen Anwendungsfall.

Der Erfindung liegt die Aufgabe zugrunde, Metallkomplexe als n-Dotanden zur Dotierung eines organischen halbleitenden Matrixmaterials, insbesondere zur Herstellung elektronischer Bauelemente anzugeben, die insbesondere auch zur Herstellung von E-lektronentransportmaterialien für organische Leuchtdioden (OLED) ausreichend niedrige Oxidationspotentiale aufweisen, ohne störende Einflüsse auf das Matrixmaterial zu haben, und eine wirksame Erhöhung der Ladungsträgeranzahl in dem Matrixmaterial bewirken und vorzugsweise vergleichsweise einfach handhabbar sind. Ferner ist es eine Aufgabe der Erfindung, Verfahren zur Herstellung der Dotanden bereitzustellen.

Diese Aufgaben werden durch die Merkmale der unabhängigen Ansprüche gelöst. Ferner wird ein organisches halbleitendes Material mit einer Verbindung eines solchen neutralen elektronenreichen Metallkomplexes als n-Dotand bereitgestellt. Bevorzugte Ausführungsformen ergeben sich aus den Unteransprüchen.

Dadurch, dass ein elektronenreicher Metallkomplex in neutraler Form als n-Dotand gegenüber dem organischen halbleitenden Matrixmaterial eingesetzt wird, liegt ein wesentlich stärkerer Donor vor, als bei bisher bekannten organischen Donorverbindungen. Ferner können durch die Bereitstellung eines neutralen elektronenreichen Metallkomplexes gegenüber anderen n-Dotanden in Form organischer Verbindung die Donor-Eigenschaften der Verbindung durch Auswahl eines geeigneten Zentralatoms und damit deren Oxidationspotential variiert werden. Die erfindungsgemäßen n-Dotanden weisen somit vorzugsweise ein sehr niedriges Oxidationspotential auf. Insbesondere kann durch die erfindungsgemäßen n-Dotanden die Leitfähigkeit von Ladungstransportschichten wesentlich erhöht und/oder der Übergang der Ladungsträger zwischen Kontakten und organischer Schicht bei Anwendungen als elektronisches Bauelement wesentlich verbessert werden.

Die erfindungsgemäßen Metallkomplexe stellen vorzugsweise isolierte Moleküle dar, die somit vorzugsweise in der jeweiligen halbleitenden Schicht als isolierte Moleküle vorliegen, die nicht durch chemische Bindungen untereinander und/oder an eine Matrix und/oder an eine andere Komponente fixiert sind. Vorzugsweise werden die Valenzelektronen der Metallzentralatome, abgesehen von den dem Metallatom unmittelbar zuzuordnenden Valenzelektronen des Komplexes, somit im wesentlichen oder vollständig von den Liganden des Komplexes und den Metallatomen des Komplexes, die innerhalb der durch die Liganden gebildeten vorzugsweise zumindest im wesentlichen geschlossenen Koordinationssphäre angeordnet sind, bereitgestellt. Es versteht sich, dass einzelne Metallkomplexe jeweils untereinander oder mit anderen Komponenten wie dem Matrixmaterial gebunden sein können, um gegebenenfalls die Metallkomplexe zu immobilisieren. Hierzu können beispielsweise die Liganden geeignete funktionelle Gruppen aufweisen, die miteinander verbindbar sind, beispielsweise ungesättigte Gruppen, die miteinander unter Bildung eines Oligomeren oder Polymeren linear oder verzweigt reagieren können.

Das komplexierte Zentralatom kann eine formale Valenzelektronenzahl VE von 16 oder mehr aufweisen, beispielsweise 18 oder 19 oder 20 oder 21 oder mehr Valenzelektronen. Das Zentralatom kann hierbei insbesondere ein Metallatom der ersten Übergangsmetallperiode, ein Metallatom der zweiten Übergangsmetallperiode oder ein Metallatom der dritten Übergangsmetallperiode darstellen. Unabhängig hiervon oder in Kombination hiermit sind die erfindungsgemäßen Komplexe zumindest zweikernige Komplexe mit einer Metall-Metall-Bindung zwischen den Zentralatomen, wodurch jeweils besonders elektronenreiche Metallkomplexe mit einer hohen Elektronendichte am Zentralatom des Metallkomplexes bereitgestellt werden können.

Besonders bevorzugt ist als Zentralatom des elektronenreichen Metallkomplexes ein neutrales oder geladenes Übergangsmetallatom. Das Zentralatom kann beispielsweise ein Metallatom aus der Gruppe der ersten Übergangsmetallperiode (Scandium bis Zink) sein, oder ein Metall der zweiten Übergangsmetallperiode (Yttrium bis Cadmium), z.B. Rhodium, Palladium, Silber und Cadmium sein, oder ein Metall der dritten Übergangsmetallperiode, einschließlich jeweils Lanthaniden und Actiniden. Das Zentralatom kann insbesondere ein Metall der 7. bis 10. Gruppe sein. Das Übergangsmetall des mindestens einen Zentralatoms kann auch jeweils eines der folgenden Elemente sein: V, Cr, Mn, Fe, Co, Ni, Cu, Zn, Nd, Ta, Mo, W, Rh, Ir, Pd, Pt. Besonders bevorzugt ist das Übergangsmetallatom ausgewählt aus der Gruppe Mn, Fe, Co, Ni, Cu, Zn, beispielsweise ausgewählt aus der Gruppe Fe, Co, Ni. Ferner kann das Übergangsmetallatom ausgewählt sein aus der Gruppe Cr, Mo, W. Das Übergangsmetallatom kann auch ausgewählt sein aus der Gruppe V, Nb, Ta oder aus der Gruppe Ir, Pt, Au, Hg. Für verschiedene Anwendungszwecke sind jedoch auch Metallkomplexe mit einer geringeren formalen Valenzelektronenzahl am Metallzentralatom des Komplexes bzw. mit einer niedrigeren Elektronendichte am Metallzentralatom einsetzbar.

Das Übergangsmetallatom kann in dem erfindungsgemäß verwendeten neutralen Metallkomplex als Neutralatom vorliegen oder als geladenes Übergangsmetallatom, vorzugsweise mit einer Formalladung von 0 bis 3, beispielsweise einer Formalladung von 0, 1 oder 2, wobei das Zentralatom insbesondere ein Atom der ersten Übergangsmetallperiode darstellen kann. Die Ladung des Zentralatoms, welches ein Atom der ersten, zweiten oder dritten Übergangsmetallperiode darstellen kann, kann auch von 0 verschieden sein.

Der erfindungsgemäße Metallkomplex ist ein mehrkerniger Metallkomplex. Der Metallkomplex ist ein mehrkerniger Metallkomplex mit vier Liganden, die an zwei Metallzentralatome binden. Der Metallkomplex weist hierbei eine Metall-Metall-Bindungen auf, die jeweils Metall-Metall-Einfachbindung oder Metall-Metall-Mehrfachbindung darstellen kann. Die Metallkomplexe stellen jeweils vorzugsweise isolierte Moleküle dar.

Die Metallatome mehrkerniger Metallkomplexe sind sämtlich Übergangsmetallatome, insbesondere der 6ten oder 7ten bis 10ten Gruppe, beispielsweise ausgewählt aus der Gruppe Cr, Mn, Fe, Co, Ni, Cu, Zn, Mo, W.

Ein derartiger Metallkomplex kann beispielsweise ein sogenannter Paddlewheel-Komplex 65 sein, wobei zwei Metallzentralatome, insbesondere Übergangsmetallzentralatome durch 4 zweizähnige Liganden, die an beide Metallzentralatome jeweils ein Ligandenatom binden, überbrückt werden. Die Metallatome sind hierbei 4-fach koordiniert:

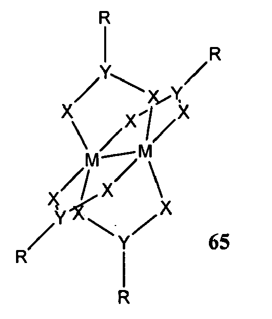

Eines oder beide Metallzentralatome M können wahlweise auch jeweils unabhängig voneinander mit zumindest einem weiteren Liganden komplexiert sein, wie beispielsweise Phosphin oder andere, die insbesondere axial (terminal) zu der M-M-Bindung angeordnet sein können.

Insbesondere können die mehrkernigen Metallkomplexe mindestens ein Atom aus der Gruppe Mn, Fe, Co, Ni, Cu, Zn, insbesondere ein Atom aus der Gruppe Fe, Co, Ni oder mindestens ein Atom ausgewählt aus der Gruppe Cr, Mo, W, insbesondere auch Mo, W aufweisen, wobei vorzugsweise sämtliche Zentralatome des neutralen Metallkomplexes identisch sind. Generell kann M ein Übergangsmetallatom sein, beispielsweise ein Übergangsmetallatom der ersten, der zweiten oder der dritten Übergangsmetallperiode oder ein Atom der 6ten oder 7ten bis 10ten Übergangsmetallgruppe. Beide Metallatome M können hierbei jeweils gleich oder verschieden voneinander sein.

Aus der oben genannten Aufzählung werden die Strukturtypen 65a, 65b, 65c und 65d beansprucht, die im Folgenden näher beschrieben werden: 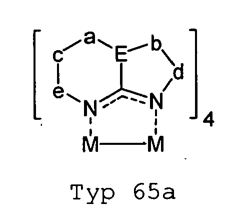 wobei
- die Strukturelemente a-e die Bedeutung: a = -CR₁R₂-, b = -CR₃R₄-, c = -CR₅R₆-, d = -CR₇R₈- und e = -CR₉R₁₀- haben können, wobei R₁, R₂, R₃, R₄, R₅, R₆, R₇, R₈, R₉ und R₁₀ gleichzeitig oder unabhängig voneinander H, Alkyl mit C₁-C₂₀, Cycloalkyl mit C₁-C₂₀, Alkenyl mit C₁-C₂₀, Alkinyl mit C₁-C₂₀,Aryl, Heteroaryl, - NR₂ oder -OR sind, vorzugsweise sind R₁, R₃, R₅, R₇, R₉ = H und R₂, R₄, R₆, R₈, R₁₀ = Alkyl mit C₁-C₂₀, Cycloalkyl mit C₁₋C₂₀, Alkenyl mit C₁-C₂₀, Alkinyl mit C₁-C₂₀, Aryl, Heteroaryl, -NR₂ oder -OR, oder
- wahlweise a oder b oder e oder d NR sein kann mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- wahlweise a und d oder b und e NR sein können mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- bei c C durch Si ersetzt ist,
- wobei die Bindungen b-d und c-e oder b-d und a-c gleichzeitig oder unabhängig voneinander ungesättigt sein können,
- wobei die Bindungen b-d, a-c und c-e gleichzeitig oder unabhängig voneinander Teil eines gesättigten oder ungesättigten Ringsystems sein können, welches auch die Heteroelemente O, S, Se, N, P, Si, Ge, Sn enthalten kann, oder
- wobei die Bindungen b-d, a-c und c-e gleichzeitig oder unabhängig voneinander Teil eines aromatischen oder kondensierten aromatischen Ringsystems sein können, welches auch die Heteroelemente O, S, Se, N, enthalten kann,
- wobei das Atom E ein Hauptgruppenelement ist, bevorzugt ausgewählt aus der Gruppe N, P, As, Sb, ohne auf diese beschränkt zu sein,
- wobei das Strukturelement a-E-b wahlweise Bestandteil eines gesättigten oder ungesättigten Ringsystems sein kann, welches auch die Heteroelemente O, S, Se, N, P, Si, Ge, Sn enthalten kann, oder
- das Strukturelement a-E-b wahlweise Bestandteil eines aromatischen Ringsystems sein kann, welches auch die Heteroelemente O, S, Se, N, enthalten kann,
- wobei das Metall M ein Übergangsmetall ist, vorzugsweise W oder Mo; 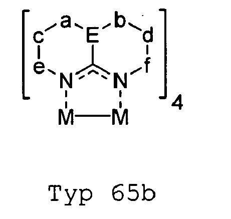
wobei
- die Strukturelemente a-f die Bedeutung: a= -CR₁R₂-, b = -CR₃R₄-, c = -CR₅R₆-, d = -CR₇R₈-, e = -CR₉R₁₀- und f = CR₁₁R₁₂ haben können, wobei R₁, R₂, R₃, R₄, R₅, R₆, R₇, R₈, R₉, R₁₀, R₁₁ und R₁₂ Wasserstoff, Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR sind, vorzugsweise sind R₁, R₃, R₅, R₇, R₉, R₁₁ = H und R₂, R₄, R₆, R₈, R₁₀, R₁₂ = Alkyl mit C₁-C₂₀, Cycloalkyl mit C₁₋C₂₀, Alkenyl mit C₁-C₂₀, Alkinyl mit C₁-C₂₀, Aryl, Heteroaryl, - NR₂ oder -OR, wobei hiervon die Struktur 65b mit R₁, R₂, R₃, R₄, R₅, R₆, R₇, R₈, R₉, R₁₀, R₁₁ und R₁₂ = H ausgenommen ist, oder
- bei den Strukturelementen c und/oder d C durch Si ersetzt sein kann, oder
- wahlweise a oder b oder e oder f NR sein kann mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- wahlweise a und f oder b und e NR sein können mit R = Alkyl mit C₁-C₂₀, Cycloalkyl mit C₁-C₂₀, Alkenyl mit C₁-C₂₀, Alkinyl mit C₁-C₂₀, Aryl, Heteroaryl,
- wobei die Bindungen a-c, b-d, c-e und d-f, aber nicht gleichzeitig a-c und c-e und nicht gleichzeitig b-d und d-f ungesättigt sein können,
- wobei die Bindungen a-c, b-d, c-e und d-f Teil eines gesättigten oder ungesättigten Ringsystems sein können, welches auch die Heteroelemente O, S, Se, N, P, Si, Ge, Sn enthalten kann, oder
- die Bindungen a-c, b-d, c-e und d-f Teil eines aromatischen oder kondensierten aromatischen Ringsystems sein können, welches auch die Heteroelemente O, S, Se, N, enthalten kann,
- wobei das Atom E ein Hauptgruppenelement ist, bevorzugt ausgewählt aus der Gruppe N, P, As, Sb, ohne auf diese beschränkt zu sein,
- wobei das Strukturelement a-E-b wahlweise Bestandteil eines gesättigten oder ungesättigten Ringsystems sein kann, welches auch die Heteroelemente O, S, Se, N, P, Si, Ge, Sn enthalten kann, oder
- das Strukturelement a-E-b wahlweise Bestandteil eines aromatischen Ringsystems sein kann, welches auch die Heteroelemente O, S, Se, N, enthalten kann,
- wobei das Metall M ein Übergangsmetall, vorzugsweise W oder Mo ist; 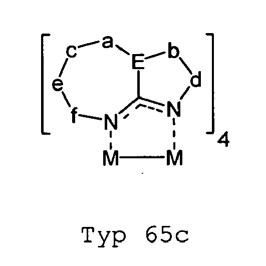
wobei
- die Strukturelemente a-f die Bedeutung: a = -CR₁R₂-, b = -CR₃R₄-, c = -CR₅R₆-, d = -CR₇R₈-, e = -CR₉R₁₀- und f = CR₁₁R₁₂ haben können, wobei R₁, R₂, R₃, R₄, R₅, R₆, R₇, R₈, Rg, R₁₀, R₁₁ und R₁₂ gleichzeitig oder unabhängig voneinander H, Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR sein kann; vorzugsweise ist R₁, R₃, R₅, R₇, R₉, R₁₁ = H und R₂, R₄, R₆, R₈, R₁₀, R₁₂ = Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR, oder
- bei c oder e C durch Si ersetzt sein kann, oder
- wahlweise a oder b oder d oder f NR sein kann mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- wahlweise a und d oder b und f NR sein können mit R = Alkyl mit C₁-C₂₀, Cycloalkyl mit C₁-C₂₀, Alkenyl mit C₁-C₂₀, Alkinyl mit C₁-C₂₀, Aryl, Heteroaryl,
- wobei die Bindungen a-c, c-e, e-f und b-d, aber nicht gleichzeitig a-c, c-e und e-f und nicht gleichzeitig a-c und c-e und nicht gleichzeitig c-e und e-fungesättigt sein können,
- wobei die Bindungen a-c, c-e, e-f und b-d Teil eines gesättigten oder ungesättigten Ringsystems sein können, welches auch die Heteroelemente O, S, Se, N, P, Si, Ge, Sn enthalten kann, oder
- die Bindungen a-c, c-e, e-f und b-d Teil eines aromatischen oder kondensierten aromatischen Ringsystems sein können, welches auch die Heteroelemente O, S, Se, N, enthalten kann,
- wobei das Atom E ein Hauptgruppenelement ist, bevorzugt ausgewählt aus der Gruppe N, P, As, Sb, ohne auf diese beschränkt zu sein,
- wobei das Strukturelement a-E-b wahlweise Bestandteil eines gesättigten oder ungesättigten Ringsystems sein kann, welches auch die Heteroelemente O, S, Se, N, P, Si, Ge, Sn enthalten kann, oder
- das Strukturelement a-E-b wahlweise Bestandteil eines aromatischen Ringsystems sein kann, welches auch die Heteroelemente O, S, Se, N, enthalten kann,
- wobei das Metall M ein Übergangsmetall ist, vorzugsweise W oder Mo; oder 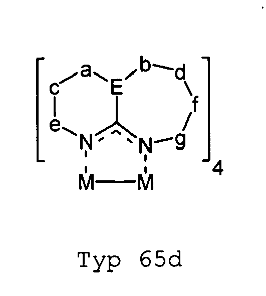
- wobei die Strukturelemente a-g die Bedeutung: a = - CR₁R₂-, b = -CR₃R₄-, c = -CR₅R₆-, d = -CR₇R₈-, e = - CR₉R₁₀-, f = CR₁₁R₁₂ und g = CR₁₃R₁₄ haben können, wobei R₁, R₂, R₃, R₄, R₅, R₆, R₇, R₈, R₉, R₁₀, R₁₁, R₁₂, R₁₃ und R₁₄ gleichzeitig oder unabhängig voneinander H, Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR sein kann; vorzugsweise ist R₁, R₃, R₅, R₇, R₉, R₁₁, R₁₃ = H und R₂, R₄, R₆, R₈, R₁₀, R₁₂, R₁₄ = Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR, oder
- bei c, d und f, jedoch nicht d und f gleichzeitig, C durch Si ersetzt sein kann, oder
- wahlweise a oder b oder e oder g NR sein kann mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- wahlweise a und g oder b und e NR sein können mit R = Alkyl mit C₁-C₂₀, Cycloalkyl mit C₁-C₂₀, Alkenyl mit C₁-C₂₀, Alkinyl mit C₁-C₂₀, Aryl, Heteroaryl,
- wobei die Bindungen a-c, c-e, b-d, d-f und f-g, aber nicht gleichzeitig a-c und c-e, und nicht gleichzeitig b-d, d-f und f-g, und nicht gleichzeitig b-d und d-f, und nicht gleichzeitig d-f und f-g, ungesättigt sein können,
- wobei die Bindungen a-c, c-e, b-d, d-f und f-g Teil eines gesättigten oder ungesättigten Ringsystems sein können, welches auch die Heteroelemente O, S, Se, N, P, Si, Ge, Sn enthalten kann, oder
- die Bindungen a-c, c-e, b-d, d-f und f-g Teil eines aromatischen oder kondensierten aromatischen Ringsystems sein können, welches auch die Heteroelemente O, S, Se, N, enthalten kann,
- wobei das Atom E ein Hauptgruppenelement ist, bevorzugt ausgewählt aus der Gruppe N, P, As, Sb, ohne auf diese beschränkt zu sein,
- wobei das Strukturelement a-E-b wahlweise Bestandteil eines gesättigten oder ungesättigten Ringsystems sein kann, welches auch die Heteroelemente O, S, Se, N, P, Si, Ge, Sn enthalten kann, oder
- das Strukturelement a-E-b wahlweise Bestandteil eines aromatischen Ringsystems sein kann, welches auch die Heteroelemente O, S, Se, N, enthalten kann
- wobei das Metall M ein Übergangsmetall ist, vorzugsweise W oder Mo.

Für die Reste R in den Strukturen 65a-65d sind die Definitionen für die Struktur 65, wie oben beschrieben, einsetzbar.

### Ionisationspotential/Oxidationspotential

Vorzugsweise weist der erfindungsgemäße Metallkomplex ein Ionisationspotential in der Gasphase von ≤ 6,4 eV, vorzugsweise von ≤ 6 eV, insbesondere ≤ 5,5 eV auf. Insbesondere kann das Ionisationspotential des Komplexes in der Gasphase ≤ 5,0 eV oder ≤ 4,5 eV sein.

Das Gasphasenionisationspotential Ipg der erfindungsgemäß einsetzbaren Verbindungen kann beispielsweise gegenüber Tetrathiafulvalen (TTF) bestimmt werden, welches beträgt: Ipg = 6,4 eV (siehe R. Gleiter, E. Schmidt, D. O. Cowan, J P. Ferraris, J. Electr. Spec. Rel. Phenom. 2, 207 (1973)).

Das Oxidationspotential von TTF ist E1/2(ox) = -0,09 V gegenüber Fe/Fe+ (Ferrocen/Ferrocenium) (M. Iyoda, T. Takano, N. O-tani, K. Ugawa, M. Yoshida, H. Matsuyama, Y. Kuwatani, Chem. Lett., 1310 (2001)). Ausgehend von diesem Referenzpunkt kann somit das Redoxpotential der erfindungsgemäßen n-Dotanden gegenüber Ferrocen/Ferrocenium ≤ -0,09 V, vorzugsweise ≤ -0,6 V, besonders bevorzugt ≤ -1,1 V betragen, beispielsweise ≤ -1,6 V oder ≤ -2,1 V betragen, ohne hierauf beschränkt zu sein.

Das Oxidationspotential gegenüber Ferrocen/Ferrocenium kann beispielsweise cyclovoltammetrisch bestimmt werden. Das Potential ist hierbei weitgehend unabhängig von dem gewählten Elektrolytsystem und kann gemäß IUPAC Empfehlung (Gritzner, G.; Kuta, J. Pure Appl. Chem. 1984, 56, 461-466) bestimmt werden. Das Elektrolytsystem muss ein ausreichend großes elektrochemisches Fenster und eine ausreichende Löslichkeit der Donorverbindung aufweisen. Als Elektrolytsystem ist beispielsweise geeignet A-cetronitril / 1M LiClO₄/Pt Elektroden, wobei auch andere geeignete Elektrolytsysteme einsetzbar sind.

### Dampdfruck

Der Dampfdruck des erfindungsgemäß eingesetzten Komplexes kann insbesondere bei 30°C < 10⁻³ Pa sein, beispielsweise ≤ 5 x 10⁻⁴ Pa oder ≤ 1 x 10⁻⁴ Pa.

Die jeweils verwendeten erfindungsgemäßen n-Dotanden und/oder die jeweils verwendeten Komplexe können luftstabil sein, gegebenenfalls können die jeweils verwendeten erfindungsgemäßen n-Dotanden und/oder Komplexe jeweils auch luftinstabil sein.

### Synthese der erfindungsgemäßen n-Dotandenkomplexe und deren Liganden

Es wurde ein neues Verfahren entwickelt, nach dem sich die Paddlewheel Komplexe vom Typ 65a-d effizient in einer Einstufensynthese darstellen lassen. Dazu wird ein entsprechendes anorganisches Metallsalz mit freien Basen der in 65 a-d angegebenen Liganden und einem geeigneten starken Reduktionsmittel in einem geeigneten organischen Lösungsmittel zum Rückfluß erhitzt, bis die Umsetzung vollständig abgelaufen ist. Als geeignete Lösungsmittel werden vorzugsweise solche eingesetzt, in denen die gebildeten Komplexe eine hinreichende Stabilität aufweisen, vorzugsweise jedoch Dialkylether, cyclische Ether, cyclische und offenkettige Polyether wie 1,4-Dioxan, Dimethoxyethan, etc., Aromaten und Mischungen derselben.
Geeignete Reduktionsmittel sind beispielsweise unedle Metalle, bevorzugt Alkalimetalle wie Natrium, Kalium und Cäsium.
Die Komplexe werden nach Abtrennen der anorganischen Nebenprodukte durch Kristallisation, Fällen oder Sublimation isoliert.

Durch die neuartige Einstufensynthese wird ein zeit und resourcensparender Zugang zu Komplexen des Typs W₂L₄ eröffnet.

Im Weiteren folgen Ausführungsbeispiele:

### Synthese der Liganden und ihrer Vorstufen

### Beispiel 1:

### 1. Imidazo[1,2-a]pyrimidin Hydroperchlorat

Die Herstellung erfolgte nach einer in der Literatur beschriebenen Methode (M. Künstlinger, E. Breitmaier, Synthesis 1983 (2), 161-162). Davon abweichend wurde das Produkt durch Zugabe von Perchlorsäure als Imidazo[1,2-a]pyrimidin Hydroperchlorat isoliert.
Fp. 195 °C
¹H-NMR (500 MHz, CD₃CN) [ppm]: 8,99-8,96 (m, 2H); 7,98 (d, 1H); 7,93 (d, 1H); 7,58 (dd, 1H)
MS: m/z = 119 [M]⁺

### 2. 5,6,7,8-Tetrahydro-imidazo[1,2-a]pyrimidin

4,2 g Imidazo[1,2-a]pyrimidin Hydroperchlorat wurden in essigsaurer Lösung mit Palladium auf Aktivkohle 8 h unter H₂-Zufuhr erwärmt. Anschließende Filtration, Entfernen des Lösungsmittels und Zugabe von Diethylether lieferte das 5,6,7,8-Tetrahydro-imidazo[1,2-a]pyrimidin Hydroacetat als farblose Kristalle, die aus Ethanol umkristallisiert wurden.
Ausbeute: 3,21 g
Fp. 65°C
¹H-NMR (500 MHz, DMSO-d₆) [ppm]: 6,97 (d, 1H); 6,91 (d, 1H); 3,90 (t, 2H); 3,25 (t, 2H); 1,98 (quint., 2H)

Die Freisetzung des 5,6,7,8-Tetrahydro-imidazo[1,2-a]pyrimidins erfolgte in alkalischer Ethanollösung.
Ausbeute: 3,08 g
Fp. 110°C
¹H-NMR (500 MHz, DMSO-d₆) [ppm]: 6,51 (d, 1H); 6,36 (d, 1H); 6,09 (s, 1H); 3,80 (t, 2H); 3,16 (t, 2H); 1,90 (quint., 2H)
MS: m/z = 123 [M]⁺

### Beispiel 2:

### 1. 2-Amino-4,6-dimethyl-1,4,5,6-tetrahydropyrimidin

1 g 2-Amino-4,6-dimethylpyrimidin wurden im salzsauren Milieu (2 M HCl) mit Palladium auf Aktivkohle als Katalysator für 14 h unter H₂-Zufuhr erwärmt. Anschließende Filtration, Entfernung des Lösungsmittels und Zugabe von Diethylether lieferte das 2-Amino-4,6-dimethyl-1,4,5,6-tetrahydropyrimidin Hydrochlorid, das aus i-Propanol/Diethylether umkristallisiert und im Vakuum getrocknet wurde.
Ausbeute: 1,03 g
Fp. 129°C
¹H-NMR (500 MHz, DMSO-d₆) [ppm]: 8,14 (s, 2H); 6,81 (s, 2H); 3,48 (m, 2H); 1,98 (d, 1H); 1,14 (d, 6H); 1,10 (d, 1H)

Die Freisetzung des 2-Amino-4,6-dimethyl-1,4,5,6-tetrahydropyrimidins erfolgte in alkalischer Ethanollösung.
¹H-NMR (500 MHz, DMSO-d₆) [ppm]: 3,46 (m, 2H); 1,98 (m, 1H); 1,13 (d, 6H); 1,10 (d, 1H)

### 2. 2,4-Dimethyl-3,4-dihydro-2H-pyrimido[1,2-a]pyrimidin Hydroperchlorat

0,66 g 2-Amino-4,6-dimethyl-1,4,5,6-tetrahydropyrimidin wurden in methanolischer Lösung unter Zugabe von Perchlorsäure mit einer äquimolaren Menge von 1,1,3,3-Tetramethoxypropan unter Rückfluss zum Sieden erhitzt. Entfernung des Lösungsmittel und Überschichten des Rückstandes mit Diethylether lieferte das 2,4-Dimethyl-3,4-dihydro-2*H*-pyrimido[1,2-a]pyrimidin Hydroperchlorat, das abfiltriert und im Vakuum getrocknet wurde.
Ausbeute: 0,46 g
¹H-NMR (500 MHz, DMSO-d₆) [ppm]: 9,86 (s, 1H); 8,75 (dd, 1H); 8,55 (dd, 1H); 6,99 (dd, 1H); 4,43 (m, 1H); 3,76 (m, 1H); 2,29 (m, 1H); 1,69 (quar, 1H); 1,57 (d, 3H); 1,27 (d, 3H)

### 3. 2,4-Dimethyl-1,3,4,6,7,8-hexahydro-2H-pyrimido[1,2-a]pyrimidin

0,5 g 2,4-Dimethyl-3,4-dihydro-2*H*-pyrimido[1,2-a]pyrimidin Hydroperchlorat wurden in essigsaurer Lösung mit Palladium auf Aktivkohle 8 h unter H₂-Zufuhr erwärmt. Anschließende Filtration, Entfernen des Lösungsmittels und Zugabe von Diethylether lieferte das 2,4-Dimethyl-1,3,4,6,7,8-hexahydro-2*H-*pyrimido[1,2-a]pyrimidin Hydroacetat als farblose Kristalle, die aus Ethanol umkristallisiert wurden.
Ausbeute: 0,37 g
Fp. 101 °C
¹H-NMR (500 MHz, DMSO-d₆) [ppm]: 7,47 (s, 1H); 7,09 (s, 1H); 3,50-3,55 (m, 1H); 3,43-3,39 (m, 1H); 3,35-3,21 (m, 3H); 3,05-3,03 (m, 1H); 2,11 (m, 1H); 1,95-1,91 (m, 1H); 1,78-1,71 (m, 1H); 1,37-1,30 (quar, 1H); 1,24 (d, 3H); 1,14 (d, 3H)

Die Freisetzung des 2,4-Dimethyl-1,3,4,6,7,8-hexahydro-2*H-*pyrimido[1,2-a]pyrimidins erfolgte in alkalischer Ethanollösung.
Ausbeute: 0,1 g
Fp. 133 °C
¹H-NMR (500 MHz, DMSO-d₆) [ppm]: 3,24-3,16 (m, 3H); 3,16-3,14 (m, 1H); 3,09-2,93 (m, 1H); 2,86-2,83 (m, 1H); 1,89-1,85 (m, 1H); 1,77-1,73 (m, 1H); 1,65-1,58 (m, 1H); 1,17-1,10 (m, 4H); 0,97 (d, 3H)
MS: m/z = 167 [M]⁺

### Beispiel 3:

### 1. Benzimidazo[1,2-a]pyrimidin Hydroperchlorat

Die Herstellung erfolgte nach einer in der Literatur beschriebenen Methode (M. Künstlinger, E. Breitmaier, Synthesis 1983 (2), 161-162). Davon abweichend wurde das Produkt durch Zugabe von Perchlorsäure als Benzimidazo[1,2-a]pyrimidin Hydroperchlorat isoliert.
Fp. 245 °C
¹H-NMR (500 MHz, DMSO-d₆) [ppm]: 9,98 (dd, 1H); 9,26 (dd, 1H); 8,60 (d, 1H); 7,95 (d, 1H); 7,86-7,81 (m, 2H); 7,73 (t, 1H)

### 2. 1,2,3,4-Tetrahydro-benzimidazo[1,2-a]pyrimidin

0,602 g Benzimidazo[1,2-a]pyrimidin Hydroperchlorat wurden in salzsaurer Lösung (2 M HCl) mit Palladium auf Aktivkohle 9 h unter H₂-Zufuhr erwärmt. Anschließende Filtration, Entfernen des Lösungsmittels und Zugabe von Diethylether lieferte das 1,2,3,4-Tetrahydro-benzimidazo[1,2-a]pyrimidin Hydrochlorid als farblose Kristalle, die aus Ethanol umkristallisiert wurden.
Ausbeute: 0,18 g
Fp. 212 °C
¹H-NMR (500 MHz, DMSO-d₆) [ppm]: 12,62 (s, 1H); 9,18 (s, 1H); 7,47 (m, 1H); 7,38 (m, 1H); 7,27 (m, 1H); 4,08 (t, 2H); 3,48 (m, 2H); 2,14 (quint., 2H)
MS: m/z = 174 [M]⁺

Die Freisetzung des 1,2,3,4-Tetrahydro-benzimidazo[1,2-a]pyrimidins erfolgte in alkalischer Ethanollösung.
Fp. 190°C
¹H-NMR (500 MHz, DMSO-d₆) [ppm]: 7,13-7,07 (m, 3H); 6,92 (m, 1H); 6,85 (m, 1H); 3,96 (t, 2H); 3,31 (t, 2H); 2,03 (quint., 2H)
MS: m/z = 173 [M]⁺

### Allgemeine Synthese der Komplexe des Typs M₂L₄

MCl₄ (WCl₄, 1,00 g, 3,07 mmol), mindestens 2 Äquivalente des jeweiligen Liganden (9,21 mmol) und Kalium im Überschuss (ca. 1 g) werden in 50 mL THF zum Rückfluss erhitzt. Danach lässt man abkühlen und filtriert die Mutterlauge ab. Das Filtrat wird zur Trockene eingeengt und mit Toluol extrahiert. Das Produkt wird mit Hexan als brauner Feststoff gefällt, durch Filtration isoliert und im Hochvakuum getrocknet. Ausbeuten um 30%.

### Beispiel 4:

### Tetrakis[tetrahydro-imidazo[1,2-a]pyrimidinato]diwolfram-II

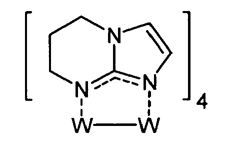

Synthese wie oben beschrieben mit 1,13g des Liganden 5,6,7,8-Tetrahydro-imidazo[1,2-*a*]pyrimidin.
¹H-NMR (500 MHz, C₆D₆) [ppm]: 6,7-6,2 (br, 2H); 3,8-3,3 (br, 4H); 1,9-1,3 (br, 2H).

### Beispiel 5:

### Tetrakis[dimethyl-1,3,4,6,7,8-hexahydro-2H-pyrimido-1,2-a]pyrimidinato]diwolfram-II

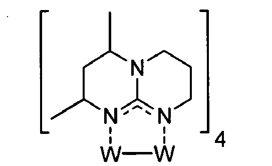

Synthese wie oben beschrieben mit 1,54g des Liganden 2,4-Dimethyl-1,3,4,6,7,8-hexahydro-2*H*-pyrimido-[1,2-*a*]pyrimidin.
¹H-NMR (500 MHz, C₆D₆) [ppm] : 3,5-2,6 (br, 4H); 2,0-1,3 (br, 4H); 1,3-0,9 (br, 6H).
ESI-MS: m/z = 184 [M⁺ + 3 OH].

### Beispiel 6:

### Tetrakis[tetrahydro-benzo[4,5]imidazo[1,2]a]pyrimidinato]diwolfram-II

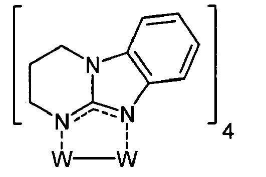

Synthese wie oben beschrieben mit 1,54g des Liganden 1,2,3,4-Tetrahydro-benzimidazo[1,2-a]pyrimidin.

In Abwandlung der allgemeinen Synthesevorschrift wird dieses Produkt aus der Mutterlauge mit Hexan gefällt. Der isolierte Feststoff ist nicht in Toluol löslich.
¹H-NMR (500 MHz, THF-d8) [ppm]: 6,60 (m, br, 1H); 6,55 (m, br, 1H); 6,40 (m, br, 1H); 6,34 (m, br, 1H); 3,72 (br, 2H); 3,42 (br, 2H); 1.77 (br, 2H).

### Matrixmaterialien

In der vorliegenden Erfindung werden geeignete n-Dotanden für organische halbleitende Materialien wie Elektronentransportmaterialien beschrieben, wie sie üblicherweise in elektronischen Bauelementen, einschließlich optoelektronischen Bauelementen, wie beispielsweise OLEDs, Feldeffekttransistoren oder organischen Solarzellen, verwendet werden. Die halbleitenden Materialien sind vorzugsweise intrinsisch elektronenleitend.

Das Matrixmaterial kann teilweise (> 10 oder > 25 Gew.-%) oder im Wesentlichen (> 50 Gew.-% oder > 75 Gew.-%)) oder vollständig bestehen aus einem Metallphthalocyanin-Komplex, einem Buckminster-Fulleren, gegebenenfalls auch einem Porphyrin-Komplex, insbesondere Metallporphyrinkomplex, einer Oligothiophen-, Oligophenyl-, Oligophenylenvinylen- oder Oligofluoren-Verbindung, wobei das Oligomere vorzugsweise 2-500 oder mehr, vorzugsweise 2-100 oder 2-50 oder 2-10 monomere Einheiten umfasst. Gegebenenfalls kann das Oligomer auch > 4, > 6 oder > 10 oder mehr monomere Einheiten umfassen, insbesondere auch für die oben angegebenen Bereiche, also beispielsweise 4 oder 6-10 monomere Einheiten, 6 oder 10-100 monomere Einheiten oder 10-500 monomere Einheiten. Die Monomere bzw. Oligomere können substituiert oder unsubstituiert sein, wobei auch Block- oder Mischpolymerisate aus den genannten Oligomeren vorliegen können. Die Matrix kann auch eine Mischung von Oligomeren mit verschiedenen Kettenlängen sein, wie es für gewöhnliche Polymerschichten der Fall ist.

Das Matrixmaterial kann auch eine Verbindung mit einer Triarylamin-Einheit oder eine Spiro-Bifluoren-Verbindung sein. Die genannten Matrixmaterialien können auch in Kombination miteinander vorliegen, gegebenenfalls auch in Kombination mit anderen Matrixmaterialien. Die Matrixmaterialien können elektronenschiebende Substituenten wie Alkyl- oder Alkoxy-Reste aufweisen, die eine verminderte Ionisierungsenergie aufweisen oder die Ionisierungsenergie des Matrixmaterials vermindern.

Die als Matrixmaterial eingesetzten Metallphthalocyaninkomplexe oder Porphyrinkomplexe können ein Hauptgruppenmetallatom oder Nebengruppenmetallatom aufweisen. Das Metallatom Me kann jeweils 4-, 5- oder 6-fach koordiniert sein, beispielsweise in Form von Oxo- (Me=O), Dioxo- (O=Me=O), Imin-, Diimin-, Hydroxo- , Dihydroxo-, Amino- oder Diaminokomplexen, ohne hierauf beschränkt zu sein. Der Phthalocyaninkomplex oder Porphyrinkomplex kann jeweils teilweise hydriert sein, wobei jedoch vorzugsweise das mesomere Ringsystem nicht gestört wird. Die Phthalocyaninkomplexe können als Zentralatom beispielsweise Magnesium, Zink, Eisen, Nickel, Kobalt, Magnesium, Kupfer oder Vanadyl (= VO) enthalten. Die gleichen oder andere Metallatome bzw. Oxometallatome können im Falle von Porphyrinkomplexen vorliegen.

Als n-dotierbare Matrixmaterialen können auch eingesetzt werden Quinolinatokomplexe, beispielsweise des Aluminiums oder anderer Hauptgruppenmetalle, wobei die der Quinolinatoligand auch substituiert sein kann. Insbesondere kann das Matrixmaterial Tris(8-hydroxy-quinolinato)-aluminium sein. Auch andere Aluminiumkomplexe mit O und/oder N Donoratomen können gegebenenfalls eingesetzt werden.

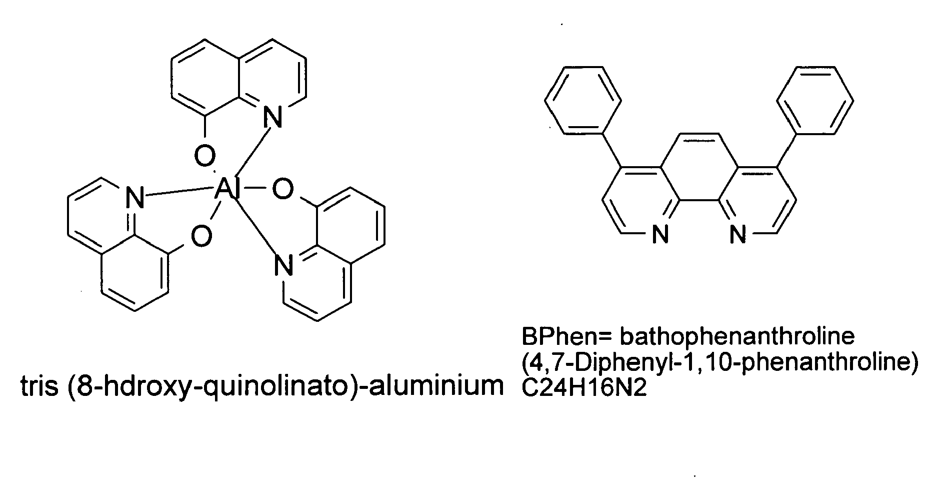

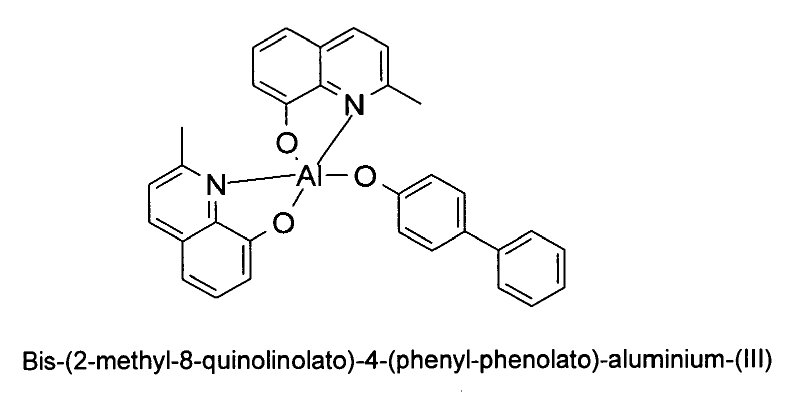

Die Quinolinatokomplexe können beispielsweise einen, zwei oder drei Quinolinatoliganden enthalten, wobei die anderen Liganden vorzugsweise mit O und/oder N-Donoratomen an das Zentralatom komplexieren, wie beispielsweise obenstehender Al-Komplex.

Als Matrixmaterial können auch Phenanthroline eingesetzt werden, die substituiert oder unsubstituiert sein können, insbesondere Aryl-substituiert, beispielsweise Phenyl- oder Naphthyl-substituiert. Insbesondere kann Bphen als Matrixmaterial eingesetzt werden.

Als Matrixmaterial können auch Heteroaromaten wie insbesondere Triazole eingesetzt werden, gegebenenfalls auch Pyrrole, Imidazole, Triazole, Pyridine, Pyrimidine, Pyridazine und dergleichen. Die Heteroaromaten sind vorzugsweise substituiert, insbesondere Aryl-substituiert, beispielsweise Phenyl- oder Naphthyl-substituiert. Insbesondere kann untenstehendes Triazol als Matrixmaterial eingesetzt werden.

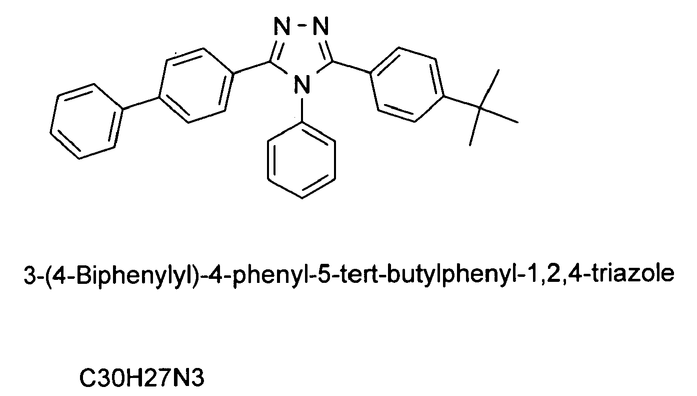

Vorzugsweise besteht das verwendete Matrixmaterial vollständig aus einem Metallphthalocyanin-Komplex, insbesondere ZnPc, einem Porphyrin-Komplex, oder einem Buckminster-Fulleren, insbesondere Fulleren C60.

Es versteht sich, dass die genannten Matrixmaterialien auch untereinander oder mit anderen Materialien gemischt im Rahmen der Erfindung einsetzbar sind. Es versteht sich, dass auch geeignete andere organische Matrixmaterialien verwendet werden können, die halbleitende Eigenschaften aufweisen.

### Dotierungskonzentration

Die Erfindung betrifft ferner ein organisches halbleitendes Material enthaltend einen erfindungsgemäßen Metallkomplex als n-Dotanden. Vorzugsweise liegt der Dotand in einer Dotierungskonzentration von ≤ 1:1 zu dem Matrixmolekül bzw. der monomeren Einheit eines polymeren Matrixmoleküls vor, vorzugsweise in einer Dotierungskonzentration von 1:2 oder kleiner, besonders bevorzugt von 1:5 oder kleiner oder 1:10 oder kleiner. Die Dotierungskonzentration kann in dem Bereich von 1:1 bis 1:100.000 oder kleiner, insbesondere in dem Bereich von 1:5 bis 10.000 oder 1:10 bis 1.000 liegen, beispielsweise in dem Bereich von 1:10 bis 1:100 oder 1:25 bis 1:50, ohne hierauf beschränkt zu sein.

### Durchführung der Dotierung

Die Dotierung des jeweiligen Matrixmaterials mit den erfindungsgemäß zu verwendenden n-Dotanden kann durch eines oder eine Kombination der folgenden Verfahren hergestellt wird:
a) Mischverdampfung im Vakuum mit einer Quelle für das Matrixmaterial und einer für den Dotanden.
b) Sequentielles Deponieren des Matrixmaterials und des n-Dotanden auf einem Substrat mit anschliessender Eindiffusion des Dotanden, insbesondere durch thermische Behandlung
c) Dotierung einer Matrixschicht durch eine Lösung von n-Dotanden mit anschliessendem Verdampfen des Lösungsmittels, insbesondere durch thermische Behandlung
d) Oberflächendotierung einer Matrixmaterialschicht durch eine oberflächlich aufgebrachte Schicht von Dotanden
e) Herstellung einer Lösung von Matrixmolekülen und Dotanden und anschließende Herstellung einer Schicht aus dieser Lösung mittels konventioneller Methoden wie beispielsweise Verdampfen des Lösungsmittels oder Aufschleudern

Die Dotierung kann gegebenenfalls auch derart erfolgen, dass der Dotand aus einer Precursor-Verbindung heraus verdampft wird, die beim Erhitzen und/oder Bestrahlung den Dotanden frei-

## Patentansprüche

1. Dotand zur Dotierung eines organischen halbleitenden Matrixmaterials, der eine Struktur aufweist, die ausgewählt ist aus der Gruppe von: 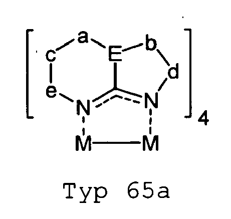 wobei
- die Strukturelemente a-e die Bedeutung: a = -CR₁R₂-, b = -CR₃R₄-, c = -CR₅R₆-, d = -CR₇R₈- und e = -CR₉R₁₀- haben können, wobei R₁, R₂, R₃, R₄, R₅, R₆, R₇, R₈, R₉ und R₁₀ gleichzeitig oder unabhängig voneinander H, Alkyl mit C₁-C₂₀, Cycloalkyl mit C₁-C₂₀, Alkenyl mit C₁-C₂₀, Alkinyl mit C₁-C₂₀,Aryl, Heteroaryl, - NR₂ oder -OR sind, vorzugsweise sind R₁, R₃, R₅, R₇, R₉ = H und R₂, R₄, R₆, R₈, R₁₀ = Alkyl mit C₁-C₂₀, Cycloalkyl mit C₁₋C₂₀, Alkenyl mit C₁-C₂₀, Alkinyl mit C₁-C₂₀, Aryl, Heteroaryl, -NR₂ oder -OR, oder
- wahlweise a oder b oder e oder d NR sein kann mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- bei c C durch Si ersetzt ist,
- wobei die Bindungen b-d und c-e oder b-d und a-c gleichzeitig oder unabhängig voneinander ungesättigt sein können,
- wobei die Bindungen b-d, a-c und c-e gleichzeitig oder unabhängig voneinander Teil eines gesättigten oder ungesättigten Ringsystems sein können, welches auch die Heteroelemente O, S, Se, N, P, Si, Ge, Sn enthalten kann, oder
- wobei die Bindungen b-d, a-c und c-e gleichzeitig oder unabhängig voneinander Teil eines aromatischen oder kondensierten aromatischen Ringsystems sein können, welches auch die Heteroelemente O, S, Se, N, enthalten kann,
- wobei das Atom E ein Hauptgruppenelement ist, bevorzugt ausgewählt aus der Gruppe N, P, As, Sb, ohne auf diese beschränkt zu sein,
- wobei das Strukturelement a-E-b wahlweise Bestandteil eines gesättigten oder ungesättigten Ringsystems sein kann, welches auch die Heteroelemente O, S, Se, N, P, Si, Ge, Sn enthalten kann, oder
- das Strukturelement a-E-b wahlweise Bestandteil eines aromatischen Ringsystems sein kann, welches auch die Heteroelemente O, S, Se, N, enthalten kann,
- wobei das Metall M ein Übergangsmetall ist, vorzugsweise W oder Mo; 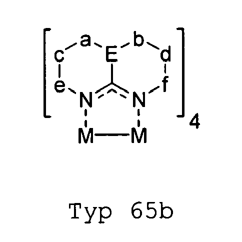
wobei
- die Strukturelemente a-f die Bedeutung: a= -CR₁R₂-, b = -CR₃R₄-, c = -CR₅R₆-, d = -CR₇R₈-, e = -CR₉R₁₀- und f = CR₁₁R₁₂ haben können, wobei R₁, R₂, R₃, R₄, R₅, R₆, R₇, R₈, R₉, R₁₀, R₁₁ und R₁₂ Wasserstoff, Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR sind, vorzugsweise sind R₁, R₃, R₅, R₇, R₉, R₁₁ = H und R₂, R₄, R₆, R₈, R₁₀, R₁₂ = Alkyl mit C₁-C₂₀, Cycloalkyl mit C₁₋C₂₀, Alkenyl mit C₁-C₂₀, Alkinyl mit C₁-C₂₀, Aryl, Heteroaryl, - NR₂ oder -OR, wobei hiervon die Struktur 65b mit R₁, R₂, R₃, R₄, R₅, R₆, R₇, R₈, R₉, R₁₀, R₁₁ und R₁₂ = H ausgenommen ist, oder
- bei den Strukturelementen c und/oder d C durch Si ersetzt sein kann, oder
- wahlweise a oder b oder e oder f NR sein kann mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- wahlweise a und f oder b und e NR sein können mit R = Alkyl mit C₁-C₂₀, Cycloalkyl mit C₁-C₂₀, Alkenyl mit C₁-C₂₀, Alkinyl mit C₁-C₂₀, Aryl, Heteroaryl,
- wobei die Bindungen a-c, b-d, c-e und d-f, aber nicht gleichzeitig a-c und c-e und nicht gleichzeitig b-d und d-f ungesättigt sein können,
- wobei die Bindungen a-c, b-d, c-e und d-f Teil eines gesättigten oder ungesättigten Ringsystems sein können, welches auch die Heteroelemente O, S, Se, N, P, Si, Ge, Sn enthalten kann, oder
- die Bindungen a-c, b-d, c-e und d-f Teil eines aromatischen oder kondensierten aromatischen Ringsystems sein können, welches auch die Heteroelemente O, S, Se, N, enthalten kann,
- wobei das Atom E ein Hauptgruppenelement ist, bevorzugt ausgewählt aus der Gruppe N, P, As, Sb, ohne auf diese beschränkt zu sein,
- wobei das Strukturelement a-E-b wahlweise Bestandteil eines gesättigten oder ungesättigten Ringsystems sein kann, welches auch die Heteroelemente O, S, Se, N, P, Si, Ge, Sn enthalten kann, oder
- das Strukturelement a-E-b wahlweise Bestandteil eines aromatischen Ringsystems sein kann, welches auch die Heteroelemente O, S, Se, N, enthalten kann,
- wobei das Metall M ein Übergangsmetall, vorzugsweise W oder Mo ist; 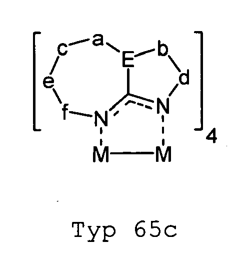
wobei
- die Strukturelemente a-f die Bedeutung: a = -CR₁R₂-, b = -CR₃R₄-, c = -CR₅R₆-, d = -CR₇R₈-, e = -CR₉R₁₀- und f = CR₁₁R₁₂ haben können, wobei R₁, R₂, R₃, R₄, R₅, R₆, R₇, R₈, Rg, R₁₀, R₁₁ und R₁₂ gleichzeitig oder unabhängig voneinander H, Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR sein kann; vorzugsweise ist R₁, R₃, R₅, R₇, R₉, R₁₁ = H und R₂, R₄, R₆, R₈, R₁₀, R₁₂ = Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR, oder
- bei c oder e C durch Si ersetzt sein kann, oder
- wahlweise a oder b oder d oder f NR sein kann mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- wahlweise a und d oder b und f NR sein können mit R = Alkyl mit C₁-C₂₀, Cycloalkyl mit C₁-C₂₀, Alkenyl mit C₁-C₂₀, Alkinyl mit C₁-C₂₀, Aryl, Heteroaryl,
- wobei die Bindungen a-c, c-e, e-f und b-d, aber nicht gleichzeitig a-c, c-e und e-f und nicht gleichzeitig a-c und c-e und nicht gleichzeitig c-e und e-f ungesättigt sein können,
- wobei die Bindungen a-c, c-e, e-f und b-d Teil eines gesättigten oder ungesättigten Ringsystems sein können, welches auch die Heteroelemente O, S, Se, N, P, Si, Ge, Sn enthalten kann, oder
- die Bindungen a-c, c-e, e-f und b-d Teil eines aromatischen oder kondensierten aromatischen Ringsystems sein können, welches auch die Heteroelemente O, S, Se, N, enthalten kann,
- wobei das Atom E ein Hauptgruppenelement ist, bevorzugt ausgewählt aus der Gruppe N, P, As, Sb, ohne auf diese beschränkt zu sein,
- wobei das Strukturelement a-E-b wahlweise Bestandteil eines gesättigten oder ungesättigten Ringsystems sein kann, welches auch die Heteroelemente O, S, Se, N, P, Si, Ge, Sn enthalten kann, oder
- das Strukturelement a-E-b wahlweise Bestandteil eines aromatischen Ringsystems sein kann, welches auch die Heteroelemente O, S, Se, N, enthalten kann,
- wobei das Metall M ein Übergangsmetall ist, vorzugsweise W oder Mo; oder 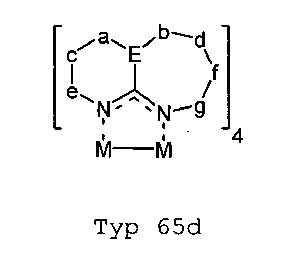
- wobei die Strukturelemente a-g die Bedeutung: a = - CR₁R₂-, b = -CR₃R₄-, c = -CR₅R₆-, d = -CR₇R₈-, e = - CR₉R₁₀-, f = CR₁₁R₁₂ und g = CR₁₃R₁₄ haben können, wobei R₁, R₂, R₃, R₄, R₅, R₆, R₇, R₈, R₉, R₁₀, R₁₁, R₁₂, R₁₃ und R₁₄ gleichzeitig oder unabhängig voneinander H, Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR sein kann; vorzugsweise ist R₁, R₃, R₅, R₇, R₉, R₁₁, R₁₃ = H und R₂, R₄, R₆, R₈, R₁₀, R₁₂, R₁₄ = Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR, oder
- bei c, d und f, jedoch nicht d und f gleichzeitig, C durch Si ersetzt sein kann, oder
- wahlweise a oder b oder e oder g NR sein kann mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- wahlweise a und g oder b und e NR sein können mit R = Alkyl mit C₁-C₂₀, Cycloalkyl mit C₁-C₂₀, Alkenyl mit C₁-C₂₀, Alkinyl mit C₁-C₂₀, Aryl, Heteroaryl,
- wobei die Bindungen a-c, c-e, b-d, d-f und f-g, aber nicht gleichzeitig a-c und c-e, und nicht gleichzeitig b-d, d-f und f-g, und nicht gleichzeitig b-d und d-f, und nicht gleichzeitig d-f und f-g, ungesättigt sein können,
- wobei die Bindungen a-c, c-e, b-d, d-f und f-g Teil eines gesättigten oder ungesättigten Ringsystems sein können, welches auch die Heteroelemente O, S, Se, N, P, Si, Ge, Sn enthalten kann, oder
- die Bindungen a-c, c-e, b-d, d-f und f-g Teil eines aromatischen oder kondensierten aromatischen Ringsystems sein können, welches auch die Heteroelemente O, S, Se, N, enthalten kann,
- wobei das Atom E ein Hauptgruppenelement ist, bevorzugt ausgewählt aus der Gruppe N, P, As, Sb, ohne auf diese beschränkt zu sein,
- wobei das Strukturelement a-E-b wahlweise Bestandteil eines gesättigten oder ungesättigten Ringsystems sein kann, welches auch die Heteroelemente O, S, Se, N, P, Si, Ge, Sn enthalten kann, oder
- das Strukturelement a-E-b wahlweise Bestandteil eines aromatischen Ringsystems sein kann, welches auch die Heteroelemente O, S, Se, N, enthalten kann
- wobei das Metall M ein Übergangsmetall ist, vorzugsweise W oder Mo.

2. Verfahren zur Herstellung eines Dotanden nach Anspruch 1, welches die Schritte umfaßt:
(a) Umsetzen eines anorganischen Metallsalzes des Zentralatoms M mit einer freien Base eines entsprechenden Liganden in einem organischen Lösungsmittel in Gegenwart eines Reduktionsmittels und Erhitzen zum Rückfluß,
(b) Isolierung des erhaltenen Dotanden-Produkts nach der Umsetzung und Trocknung.

3. Verfahren nach Anspruch 2, **dadurch gekennzeichnet, daß** das Lösungsmittel Ether, ein aromatisches Lösungsmittel oder eine Mischung derselben ist.

4. Verfahren nach Anspruch 3, **dadurch gekennzeichnet, daß** der Ether Dialkylether, cyclischer Ether, cyclischer und/oder offenkettiger Polyether ist.

5. Verfahren nach einem der Ansprüche 2 bis 4, **dadurch gekennzeichnet, daß** das Reduktionsmittel ein unedles Metall ist.

6. Verfahren nach Anspruch 5, **dadurch gekennzeichnet, daß** das unedle Metall Natrium, Kalium und/oder Cäsium ist.

7. Verfahren nach einem der Ansprüche 2 bis 6, **dadurch gekennzeichnet, daß** die Isolierung durch Kristallisation, Ausfällen und/oder Sublimation erfolgt.

8. Halbleitendes Material hergestellt unter Verwendung eines Dotanden nach Anspruch 1 in Form einer elektrisch kontaktierbaren Schicht oder eines auf einem Substrat angeordneten elektrischen Leitungspfads.

9. Organisches halbleitendes Material enthaltend zumindest eine organische Matrixverbindung und einen n-Dotanden, **dadurch gekennzeichnet, daß** der n-Dotand ein oder mehrere Dotanden nach Anspruch 1 ist.

10. Organisches halbleitendes Material nach Anspruch 9, **dadurch gekennzeichnet, daß** das molare Dotierungsverhältnis von Dotand zu Matrixmolekül bzw. das Dotierungsverhältnis von Dotand zu monomeren Einheiten eines polymeren Matrixmoleküls zwischen 1:1 und 1:100000 beträgt.

11. Verfahren zur Herstellung eines organischen halbleitenden Materials enthaltend ein organisches Matrixmolekül und einen n-Dotanden, **dadurch gekennzeichnet, daß** als n-Dotand zumindest ein oder mehrere Dotanden nach Anspruch 1 verwendet wird bzw. werden.

12. Elektronisches Bauelement mit einem elektronisch funktionell wirksamen Bereich, **dadurch gekennzeichnet, daß** der elektronisch wirksame Bereich unter Verwendung zumindest eines oder mehrerer der Dotanden nach Anspruch 1 hergestellt ist.

13. Elektronisches Bauelement nach Anspruch 12, **dadurch gekennzeichnet, daß** der elektronisch wirksame Bereich ein organisches halbleitendes Matrixmaterial aufweist, welches mit zumindest einem n-Dotanden zur Veränderung der elektronischen Eigenschaften des halbleitenden Matrixmaterials unter Verwendung zumindest eines Dotanden nach Anspruch 1 dotiert ist.

14. Elektronisches Bauelement nach Anspruch 12 oder 13 in Form einer organischen lichtemittierenden Diode (OLED), einer photovoltaischen Zelle, einer organischen Solarzelle, einer organischen Diode oder eines organischen Feldeffekttransistors, bei dem das mit zumindest einem Dotanden nach Anspruch 1 dotierte halbleitende organische Material einen elektronisch funktionell wirksamen Teil des elektronischen Bauelements darstellt.
